# EUROPEAN PATENT SPECIFICATION

(11) **EP 3 324 716 B1**
(45) Date of publication and mention of the grant of the patent: **19.01.2022**
(21) Application number: 17196858.9
(22) Date of filing: 17.10.2017
(51) Int. Cl.: H05K 7/20

(54) **SYSTEM FOR THE COOLING OF HEAT-PRODUCING ELECTRONIC COMPONENTS**
SYSTEM ZUR KÜHLUNG VON WÄRMEERZEUGENDEN ELEKTRONISCHEN BAUTEILEN
SYSTÈME DE REFROIDISSEMENT DE COMPOSANTS ÉLECTRONIQUES GÉNÉRATEURS DE CHALEUR

(30) Priority: 27.10.2016 IT 201600108608
(43) Date of publication of application: 23.05.2018
(73) Proprietor: Caciolli, Rodolfo, 50125 Firenze (IT)
(72) Inventor: Caciolli, Rodolfo, 50125 Firenze (IT)
(74) Representative: Petruzziello, Aldo

(56) References cited:
- EP-A1- 2 816 881
- WO-A1-2014/192252
- JP-A- 2010 212 533
- US-A1- 2003 128 516
- US-A1- 2012 103 571
- US-A1- 2013 077 232
- US-A1- 2014 376 178
- US-A1- 2015 009 620
- US-A1- 2015 070 846
- US-A1- 2015 233 619
- US-A1- 2016 274 628

## Description

The present invention relates to a system of cooling of heat-producing elements, more particularly electronic components contained in metal cabinets or racks, in order to dissipate the heat generated by the racks directly to the exterior without the use of refrigeration systems and/or of pumps for circulation of the cooling fluid or other machines so as to minimise the energy input while performing efficient cooling.

More particularly the present invention relates to a system of cooling suitable for removing heat from said electronic elements, maintaining them at a temperature around 60°C or below, transferring said heat directly to the exterior of the closed room containing said electronic components.

Electronic units (servers - databases) are made up of an assembly of metal cabinets, known as racks, where each of which houses a plurality of electronic boards placed in pull-out drawers, whose components release heat and have to be cooled in order to be able to operate at their optimal design temperature, generally equal to or lower than 60°C.

The cooling in these metal cabinets is performed by using finned metal heat sinks, placed in contact with the elements to be cooled, or with other more efficient systems such as for example those that use heat pipes.

These cooling systems known in the art transfer the heat subtracted from the electronic elements to the air of the room in which said racks are contained.

Therefore, the air of the room containing said racks has to be maintained at a sufficiently low temperature in order to allow cooling of the aforementioned heat sinks in order ultimately to contain the temperature of said electronic elements.

The air of the room in which said racks are contained is maintained at the necessary temperature with air conditioning systems inside the room, which are fed by refrigeration units taking up large quantities of electrical energy and requiring constant maintenance.

It is therefore highly desirable to have cooling systems with input of lower quantities of electrical energy.

In portable electronic devices, such as for example notebooks, cooling of the electronic component or board is performed in a simple manner, using a "heat pipe" (hereinafter referred to as TdC) which can be used thanks to the higher temperature at which the electronic components of the latest generations can work, generally around 60°C.

The heat pipe is a closed pipe having a system of heat exchange which can transport large quantities of heat with a very small difference in temperature between the hot and cold interfaces, and which functions on the principle of thermal conductivity and phase transition, transferring heat between two solid interfaces.

In practice the heat pipe, which references the natural cycle of the evaporation of the water forced by solar heating, transfers the heat from a hot source (i.e. electronic components which work generally at 60°C) to a cooling means via the change of state from liquid to vapour of a low boiling fluid circulating inside a closed circuit, and the successive condensation inside this closed circuit, without the use of mechanical work: the cooling fluids for air conditioning and refrigeration can be used in the abovementioned heat pipe.

More particularly, the heat pipes exploit the principle of evaporation and condensation of a gas in a closed pipe, with the effect of absorbing heat in the evaporation phase and yielding it during the condensation, where circulation of the fluid inside the pipes is due to the difference in temperature between evaporator and condenser which causes the movement of the vapour towards the coldest point.

Generally, these pipes are induced to transfer the heat taken away by the contact with the electronic components in the following two ways:
a) by means of contact with a plate kept cold by any centralised system of refrigeration;
b) by means of the connection to a finned heat sink, cooled directly by the room air which is forced on the fins by a fan.

In case a), the heat which is captured by the cold plate, passes to a cooling fluid (e.g. water) using a jump in temperature to the detriment of that existing between the heat source and the disposal means. The fluid moved by a pump transports the heat to any heat sink placed outside which releases the heat to the surrounding air. Frequently, given the reduction in the heat difference due to the effect of the intermediate exchanger, the aim is to cool the fluid to a lower temperature with the use of refrigerants in order to regain the efficiency lost in the transmission of the heat.

In case b), the heat is transported to a finned or ventilated exchanger, placed in the rack of the electronic boards and the heat is transferred to the room air which is in turn cooled by compressor air conditioning systems.

In practice the known heat pipe is used only for transferring locally the heat from the electronic components to an air heat sink which is inside the rack or to cold plates with an intermediate heat exchange.

Said heat pipe has never been used to dissipate directly outdoors the heat generated by the racks, due to the high number of electronic elements to be cooled present in a drawer of a rack, which should provide a manual cut-off valve or tap on each heat pipe but in practice there are no sufficient physical spaces for housing the necessary quantity of taps.

US 2016/274628 A1 **describes an apparatus for cooling a computer system including a primary cooling loop. The primary cooling loop includes an evaporator configured to cool at least a component of the computer system, an ambient cooled condenser connected to the evaporator, a first pump to provide a coolant flow within the cooling loop, a pressure regulator configured to maintain a selected pressure in the primary cooling loop, and a controller responsive to changes in outdoor ambient conditions and an amount of heat dissipated by the computer system and configured to dynamically adjust the pump and pressure** regulator in response thereto.

US 2012/103571 A1 describes a structure of heat dissipation of an electronic device including at least one heat pipe and a cooler. The heat pipe has a condensation end and an evaporation end opposite to each other, and the evaporation end is disposed on a heat generating element of the electronic device. The cooler is disposed on a rack and has a chamber therein, and the chamber has an inner shell having a cooling fluid therein. When the electronic device is mounted in the rack, the condensation end of the heat pipe is inserted into the cooler and positioned into the inner shell. The evaporation end absorbs the heat energy of the heat generating element, and transfers the heat energy to the condensation end, such that the cooling fluid dissipates the heat energy of the condensation end.

US 2003/128516 A1 describes a computer system having a frame and a plurality of server unit subassemblies that are insertable into the frame. Each server unit subassembly has a chassis component which engages with a frame component on the frame. Heat can transfer from the chassis component to the frame component, but the server unit subassembly can still be moved out of the frame. In one embodiment, an air duct is located over a plurality of the frame components. Heat transfers from the frame components to air flowing through the duct. A modified capillary pumped loop is used to transfer heat from a processor of the server unit subassembly to thermal components on the frame.

EP 2816881 A1 describes A cooling apparatus including 2 or more refrigerant storage units arranged in a vertical direction and configured to store refrigerants, a condensation unit disposed above the refrigerant storage units, a steam pipe for circulating gas phase refrigerants flowing out of the refrigerant storage units to the condensation unit, a liquid pipe for circulating a liquid phase refrigerant flowing out of the condensation unit to an uppermost refrigerant storage unit, and separation piping for circulating a liquid phase refrigerant flowing out of an upper refrigerant storage unit to a lower refrigerant storage unit. The liquid phase refrigerant flows into each refrigerant storage unit via an inlet and flows out from the refrigerant storage unit via a first connection port **formed below the inlet.**

The object of the present invention is that of overcoming the disadvantages of the prior art by providing a cooling system of metal cabinets or racks placed inside a room, and of the heat-producing metal elements contained therein, which requires conditioning systems having considerably smaller size with respect to those known so as to use smaller quantities of electrical energy.

A further object is that of providing such a cooling system which does not entail the transfer of the heat from the electronic elements to the room wherein the racks are contained but instead entails to transport the heat, and dissipate it, directly outdoors without the use of refrigeration systems which absorb large quantities of electrical energy, and limit the electrical energy to the minimum necessary for actuation of the fans.

Yet another object of the invention is that of providing such a system which is also simple and economical to produce and also to manage.

These objects are achieved by the cooling system according to the invention which has the features listed in the appended independent claim 1.

Advantageous embodiments of the invention are disclosed by the dependent claims.

The object of the present invention relates to a system for dissipating directly to the exterior (outdoors) the heat generated by one or more racks placed inside a room, where the heat pipes associated with the electronic elements in the drawers of the racks (internal circuits) transfer the heat directly to the outside of the room by means of one or more circuits of cooling fluid (external general circuit) which act as heat pipes, so as not to require electrical energy for the transport of the cooling fluid.

More particularly, the present system of cooling semiconductors of electronic components contained in drawers of metal cabinets or racks which are placed inside a room, comprises:
a first phase transition fluid, intended to cool said heat-producing elements housed in at least one of said drawers in order to remove the heat generated by said drawer and
maintain it at a preset temperature, said first fluid circulating in a first fluid circuit, a secondary cooling fluid, the same as said first fluid, intended to transfer directly to the outside (outdoors) the heat transferred by said first fluid, said secondary cooling fluid being circulating in a second fluid circuit which includes a heat sink placed outside of the room,
**said first and second fluid circuits being in fluid communication one with the other so as to form a heat pipe connected to said heat sink placed outdoors, said system being characterised in that in each drawer of each rack a plurality of heat pipes being placed in contact with said electronic elements,**
**the ends of each of said heat pipes being tightly connected, respectively, to a small hot collector in which vapour lines of said heat pipes converge, and to a small cold collector wherein liquid lines of said heat pipes converge,**
**each small cold collector and each small hot collector of each drawer being inside said drawer and connected with removable connection means to, respectively, a larger cold collector and a larger hot collector, said larger collectors being placed outside on the back of the rack and connected hydraulically to said sink,**
**said larger collectors and heat pipes of said electronic elements forming a continuous circuit of the loop "heat pipe" type.**

In a first embodiment, **not covered by the claims,** the system provides for the use of a particular exchanger constituted by two semi-exchangers in contact one with the other but easily detachable and with fluid circuits independent one from the other, wherein the first semi-exchanger transmits the heat, which has been subtracted from elements to be cooled, to the second semi-exchanger through simple conductive contact and temperature difference, where at least one of said semi-exchangers is a phase transition exchanger (two-phase).

The Applicant has in fact found that it is possible to use an exchanger with separable sections in the cooling of each source of heat, for example semiconductor elements or the like, said exchanger generating a positive difference of temperature with respect to the dissipation means, normally represented by the outside air, even if it is possible to provide alternative solutions of dissipation as indicated here below in detail, and with the need for separation of the single elements from the central plant without loss of coolant.

In fact, the system that constitutes the first object of the present invention does not provide for the use of pumps for circulation of the fluid which cools the electronic components of the computers and even less of coolers with compressor, so as to minimise the energy input while performing efficient cooling.

More particularly, the cooling system according to the present invention comprises at least two heat exchange elements, or semi-exchangers as defined above, which equate to two separate loop heat pipes, which are placed in contact one with the other at a respective sink plate, yet detachable and hydraulically independent one from the other, operating in different ranges of temperatures, wherein
at least one of the two semi-exchangers is a primary semi-exchanger associated with at least one container, generally a drawer of a rack, placed in a server room, generally closed, in order to cool one or more electronic components (e.g. semiconductors) contained in said drawer in such a way as to transfer the dissipation heat of said drawer to a secondary semi-exchanger,
said secondary semi-exchanger being placed inside said room in order to transfer to the outside environment the heat exchanged with a least said primary semi-exchanger, so as to subtract from said room the heat generated by said electronic components contained in said drawer of said rack.

In practice, each of the two circuits shows a loop heat pipe and the two circuits exchange heat between each other by means of conduction thanks to the plates of the two semi-exchangers which are in contact one with the other.

"*Drawer*" here is intended to identify a container, mostly with parallelepiped shape, which houses electronic components mounted on one or more electronic boards.

"*Different ranges of temperatures*" here is intended to identify the different delta of temperature (ΔT) at which the semi-exchangers work.

The heat that said secondary semi-exchanger has subtracted from the first semi-exchanger can be transported and dissipated directly to the exterior in various ways so as to subtract it from the room containing said racks, where the exterior is not always represented by the air but can also be represented, for example, by a certain flow of water which cools a plate or tube bundle condenser.

In this case, given that the condenser does not release heat towards the environment but transfers it instead to the water, said condenser can also be installed inside the room which houses the racks: the cooling water will enter at a certain temperature and will exit at a higher temperature and will then be dispersed outside (dispersion of heat).

In other cases, the same condenser can be cooled by water which will go to disperse heat in an external cooling tower, by means of partial evaporation of the water itself (adiabatic cooling). All this takes place in closed circuit, with constant reintegration of the water lost through evaporation.

The system for removing heat in a second embodiment and third embodiment of the present invention provides for the exchange of heat between interior-exterior to take place by using exclusively the system known as "heat pipe", both in its more simple "monopipe" version (third embodiment) and in the more efficient "loop" version (second embodiment) without the use of semi-exchangers in thermally conductive contact one with the other.

Further features of the invention will be made clearer by the following detailed description, referred to its embodiments purely by way of a non-limiting example, illustrated in the accompanying drawings, in which:
Figure 1a is a schematic view of a heat pipe (TdC) also known as "loop heat pipe" which illustrates the functioning thereof;
Figure 1b is a schematic perspective view of the cooling system of a first embodiment **not covered by the claims,** for cooling a single rack contained in a server room;
Figure 2a is a side view of the system of Fig. 1b;
Figure 2b is an enlarged and partially interrupted view of a drawer of the rack illustrated in Fig. 2a;
Figures 3a, 3b are plan views from above of the cooling system of Fig. 2b, respectively in the configuration of non-use (semi-exchangers not in contact) and in the configuration of use (semi-exchangers in contact one with the other);
Figure 4 is a schematic view illustrating the functioning of an embodiment of the cooling system **not according to** the present invention;
Figure 5a is a rear front view of the exchange plate of the semi-exchanger of Figs. 3a-3b;
Figures 5b, 5c are, respectively, a right-hand side view and a view from above of the exchange plate illustrated in Fig. 5a;
Figure 5d is a view in horizontal section of the exchange plate illustrated in Fig. 5a, taken along plane VI-VI;
Figure 6 is a schematic view of a server room in which the present cooling system is installed;
Figures 7a-7b are schematic perspective views of a second embodiment **according to the invention** of the cooling system for cooling a single rack contained in a server room according to the present invention;
Figure 8 is a vertical enlarged schematic view, partially interrupted, of one of the drawers of the rack illustrated in Figs. 7a-7b of the cooling system according to the second embodiment of the present invention;
Figure 9a is a vertical schematic view, partially interrupted, of the cooling system of a rack according to the second embodiment of the present invention;
Figure 9b is a schematic view of one of the heat pipes of the drawer illustrated in Fig. 9a;
Figure 9c is a sectioned view taken along line A-A indicated in Fig. 9b;
Figures 10a, 10b are plan views from above of the drawer illustrated in Fig. 9a, respectively, in the configuration in use of drawer inserted in the rack (connected) and in the configuration not in use of drawer extracted from the rack (disconnected);
Figure 11 is a schematic view of a server room in which the second embodiment of the present cooling system is installed;
Figure 12a is an enlarged view of the detail of one of the quick connectors illustrated in Fig. 9a, relating to the connected configuration;
Figure 12b illustrates one of the quick connectors illustrated in Fig. 12a, in its disconnected configuration;

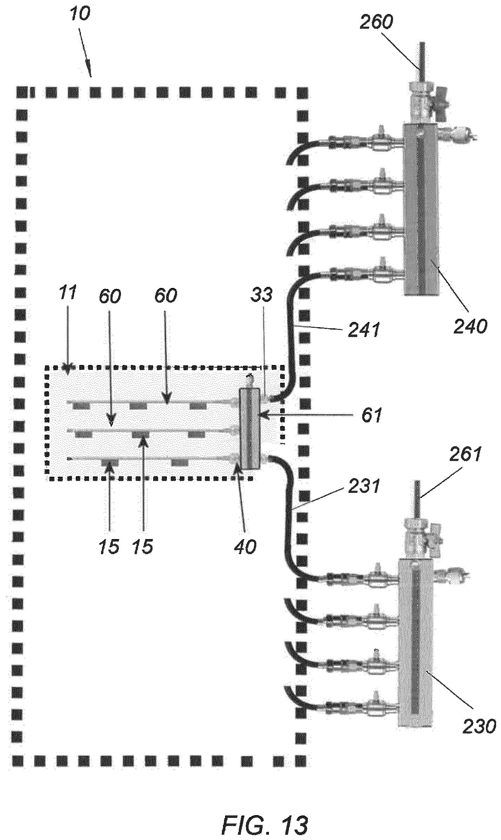

Figure 13 is a vertical schematic view of the third embodiment of the cooling system of drawers of a rack according to the present invention;

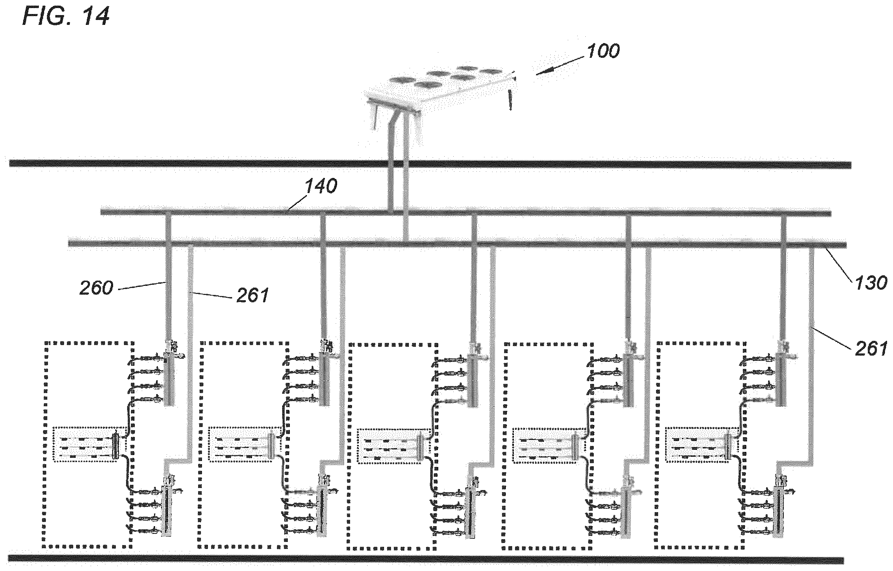

Figure 14 is a schematic view of a server room in which the third embodiment of the present cooling system is installed.

In the drawings and in the following description identical elements are identified with the same reference numerals.

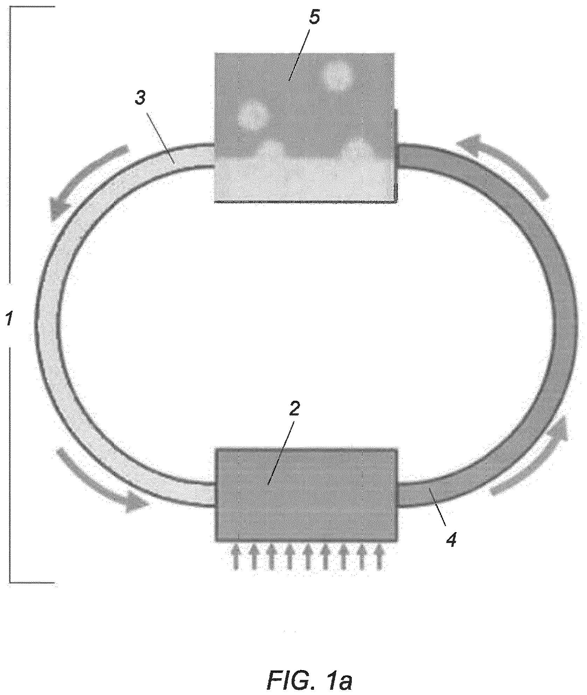

As illustrated in Figure 1a, a "heat pipe" is a closed circuit 1, generally loop, which absorbs heat from a hot source 2 (e.g. heat sink plate in copper or aluminium on which the electronic component is generally mounted whose working temperature must not exceed a certain value).

In said circuit 1 a cooling fluid 3 circulates which is then transformed into vapour 4 thanks to the heat coming from said source 2 dissipating heat: said vapour 4 moves towards the colder area 5 of the circuit 1, defined here also as compensation or plenum chamber, where it will condense, transforming again into the cooling liquid 3 without the use of mechanical work.

Therefore, in a heat pipe the exchange of heat is based on the physical phenomenon of absorption of heat during evaporation and of its release during the successive condensation.

The abovementioned heat pipe functioning has been applied to realise the present cooling system which uses two semi-exchangers operating in different ranges of temperatures, at least one of them functioning like a heat pipe having the fluid circuit independent from the other semi-exchanger, wherein said semi-exchangers are placed in contact, through respective sink plates yet detachable, in order to exchange heat one with the other.

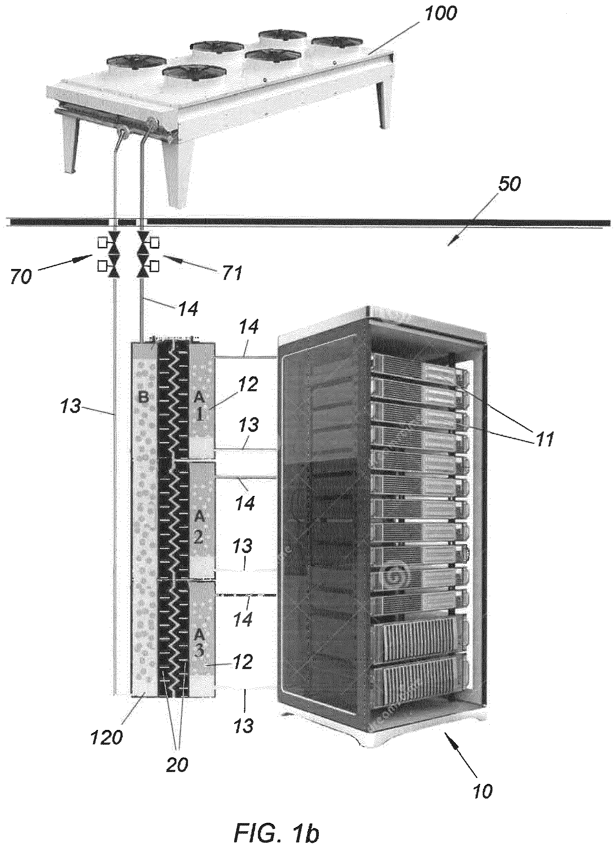

More particularly, with reference to Figure 1b, the present cooling system, **not covered by the claims**, comprises
at least one primary semi-exchanger 12 intended to cool one or more drawers 11 contained in a rack 10 (i.e. container cabinet of drawers) which is placed in a room 50 of servers - databases, generally closed, said primary semi-exchanger 12 being intended to remove the heat generated by said drawer 11 in order to maintain a predetermined temperature in said drawer;
a secondary semi-exchanger 120 in contact with one or more of said primary semi-exchangers 12 of said drawers 11 of said rack 10, said secondary semi-exchanger 120 being intended to transfer to the outside the heat transmitted by said primary semi-exchangers 12 by means of the sink plates.

In fact, the face 20 of the primary semi-exchanger 12 is connected, together with others (but always in an independent manner), to the face 20 of the larger secondary semi-exchanger 120 which receives the heat of all the drawers of a single rack, which then connects to the general dissipation plant 100 as will be illustrated in detail here below.

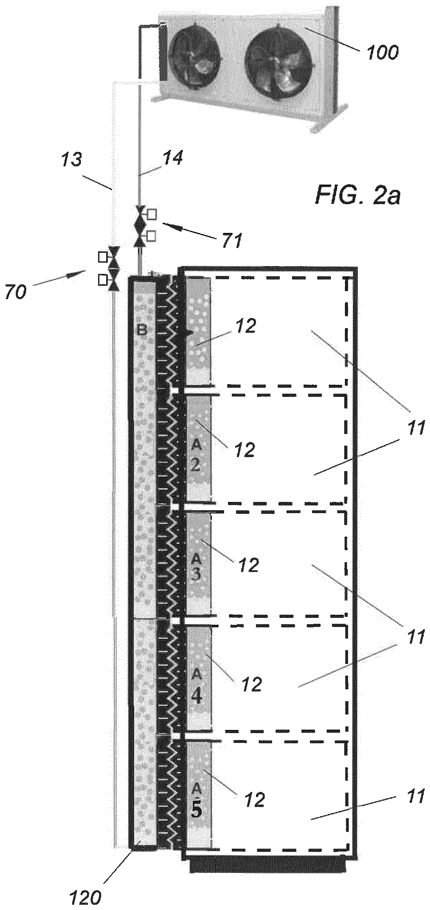

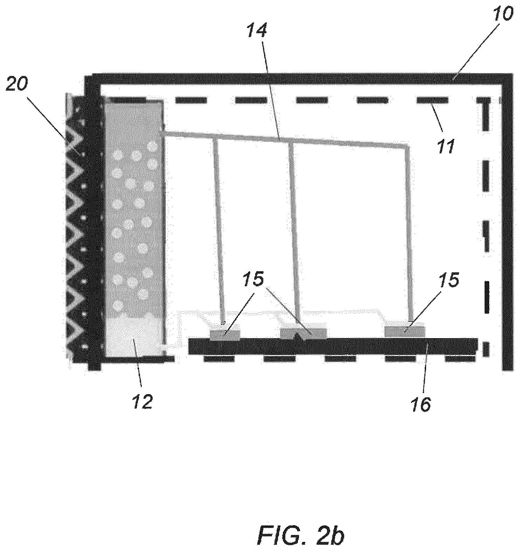

Referring to Fig. 2b, the primary semi-exchanger 12 includes a line 13 wherein the cooling liquid circulates and a line 14 wherein the vapour of said cooling liquid circulates, said fluid lines 13, 14 being in fluid communication one with the other to form a closed circuit, said primary semi-exchanger being a phase transition exchanger.

The secondary semi-exchanger 120 is preferably also a phase transition exchanger and provides a line 13 wherein a cooling liquid circulates and a line 14 wherein the vapour of said cooling liquid circulates.

In the primary semi-exchanger 12 a first cooling fluid circulates and in the secondary semi-exchanger 120 a second cooling fluid circulates, said primary and secondary fluids being able to be identical or different one from the other, yet operating with a different temperature range.

Said secondary semi-exchanger 120, in addition to being in contact with one or more primary semi-exchangers 12, is associated with a dissipation system of the heat deriving from the condensation of the secondary fluid in the secondary semi-exchanger 120: said system can be for example at least one dry cooler 100, static or ventilated, placed outside the room 50 so as to transmit directly to the outside environment (outdoors) the heat of dissipation of the rack 10, subtracting said heat from the environment of the room 50 in which the racks 11 are housed.

*"Dry coolers"* here are intended to identify air heat sinks equipped with fans, designed to cool a liquid, in the present case the cooling liquid of the secondary semi-exchanger 120 using outside air.

In fact, part of the circuit formed by said fluid lines 13, 14 of said secondary semi-exchanger 120 converges outside of said room 50, preferably in an outside air dry cooler 100, even if this is not binding for the purpose of the present invention.

Said fluid lines 13, 14 of said secondary semi-exchanger 120 provide, each, a pair of respective cut-off valves 70, 71 in order to allow any maintenance/replacements of the secondary semi-exchanger 120.

All the primary semi-exchangers 12 provided in the present system operate preferably with the same range of temperatures which is however different from the range of temperatures in which said secondary exchanger 120 operates, as will be explained in detail here below.

In an embodiment illustrated in Figure 2b, each drawer 11 is restrained to a primary semi-exchanger 12.

Moreover, each primary semi-exchanger 12 includes at least one circuit formed by a liquid line 13 and by a vapour line 14 to cool at least one respective semiconductor or electronic element 15 (e.g. processor, chipset, CPU and the like) of an electronic board 16 contained in said drawer 11.

In the case wherein said electronic board 16 contains more than one electronic element 15, provision must be made, for each primary semi-exchanger 12, for the same number of pairs of fluid lines 13, 14 as the electronic elements 15 to be cooled in such a way that each electronic element 15 is cooled by a respective circuit formed by a liquid line 13 and a vapour line 14 which detach from the primary semi-exchanger 12 or which detach from a main liquid line 13 (liquid distribution) and a main vapour line 14 (vapour collection) as illustrated in Fig. 2b.

As is known, the electronic components of a board are generally coupled to a heat sink formed by a thin plate in copper or aluminium (not illustrated in the drawings), even if other techniques of dissipation are likewise used: therefore the position and type of assembly of the fluid lines 13, 14 of a primary semi-exchanger 12 according to the invention will be determined according to the type of rack, and in any case always so as to have a thermal connection between the source of heat and the present cooling system.

As already mentioned, the liquid line 13 absorbs the dissipated heat by the electronic element 15, transforming into vapour which flows along the vapour line 14. Said vapour line 14 converges into the plenum chamber of said primary semi-exchanger 12, transforming again into liquid by means of condensation.

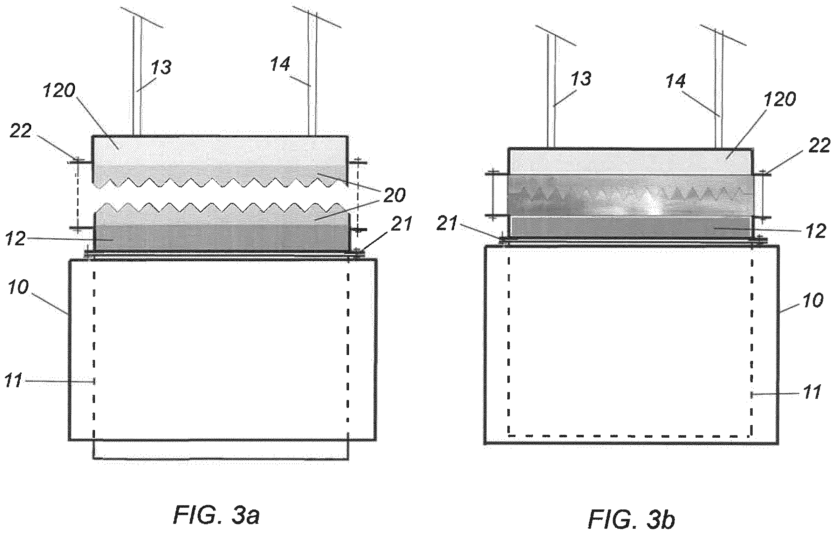

Each semi-exchanger 12 intended for the relative drawer 11 also comprises a particular exchange surface or plate 20 (Figs. 3a-3b) which acts as heat sink element, being made in copper or another material with high thermal conductivity.

Each primary semi-exchanger 12 is also attached on the back of the relevant drawer 11, by means of known magnetic or mechanical systems, such as for example screws and bolts 21, as illustrated in Figures 3a and 3b and in such a way that the exchange plate 20, which closes the plenum chamber, is outside of the relative drawer 11 so as to be able to transfer efficiently to the secondary semi-exchanger 120 all the heat which the primary semi-exchanger 12 has subtracted from the relative drawer 11.

Moreover, each primary semi-exchanger 12 is also attached to the secondary semi-exchanger 120 intended for the rack 10 by means of known mechanical or magnetic systems such as, for example, screws and bolts 22, so as to ensure the complete contact between the surfaces of the heat sink plate 20 of the primary semi-exchangers 12 and the heat sink plate 20 of the secondary semi-exchanger 120.

Since the cooling liquid is wholly contained in the closed circuit formed by said lines of fluid 13, 14 integral with the semi-exchanger 12 in turn integral with the back of the structure of the rack it is possible to extract easily each drawer 11 without losses of cooling liquid.

With the present cooling system, it is therefore possible to separate without damage or difficulty each drawer 11 from the relevant rack 10 for the necessary work of replacement or maintenance and control.

Moreover, with the use of the present cooling system it is possible to have a reduction in consumptions, in the spaces used and in maintenance.

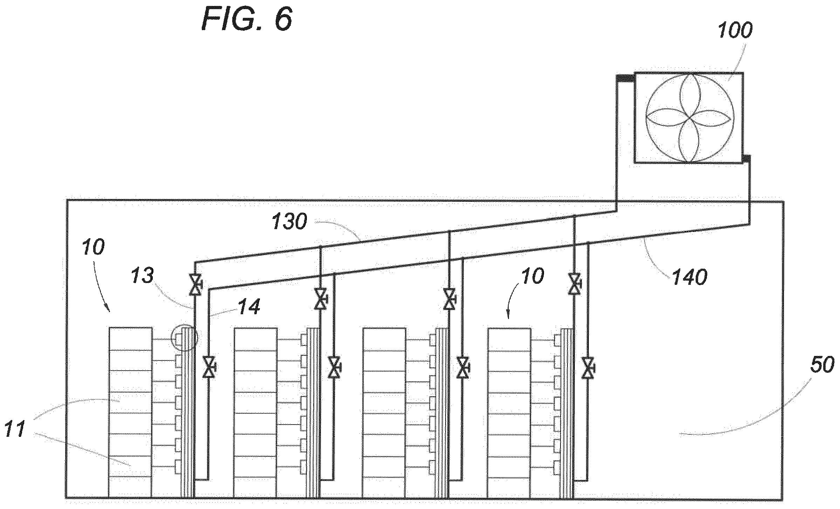

In practice, each drawer 11 is absolutely independent from the others and from the rest of the general plant for dissipation of the heat towards the outside (Fig. 6).

The heat exchange plate 20 of the primary exchangers 12 and that of the secondary semi-exchanger 120 can have a flat surface or, preferably, a surface with shaped profile to increase the surface of heat exchange through conduction.

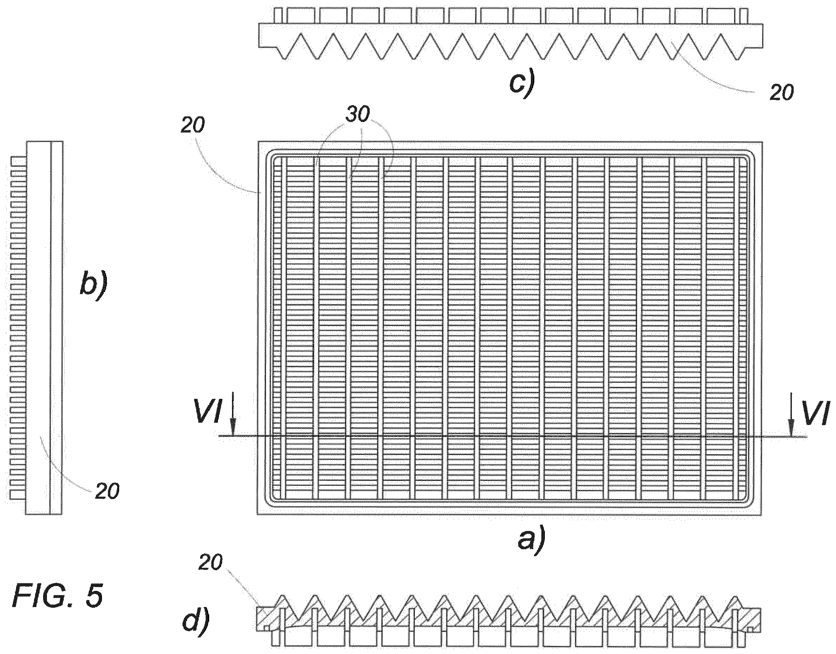

In an embodiment said exchange surface of said plate 20 of said primary exchangers 12 and secondary exchangers 120 is shaped like saw teeth, with projecting prismatic elements, as illustrated in Figs. 5a-d, even if this embodiment is not binding for the purpose of the present invention.

Moreover, at said projecting prismatic elements of said exchange plate 20 there are provided, preferably, internal grooves 30 in order to increase the exchange between said plate and the cooling fluid circulating inside the plenum chamber of said semi-exchanger 12.

It is understood that this heat sink plate 20 can be made in another way without thereby departing from the spirit of the present invention.

The secondary semi-exchanger 120 is also preferably a heat exchange unit functioning as a heat pipe, even if this is not binding for the purpose of the present invention.

It is in fact understood that said secondary semi-exchanger 120 can be, in alternative to the heat pipe, a normal circuit with circulation of water or water/glycol, without a change of physical state. In this latter case the use of a circulation pump also has to be provided.

Said secondary semi-exchanger 120 is also provided with an exchange plate 20 with an exchange surface shaped in a similar and complementary manner to that of the heat sink plate 20 of the primary semi-exchanger 12 with which it has to couple frontally.

Moreover, said secondary semi-exchanger 120 is appropriately dimensioned, according to the number of primary semi- exchangers 12 with which it has to be associated.

The plates 20 of the secondary semi-exchanger 120 and of the primary semi-exchanger 12 have in any case to be coplanar and can also be covered with conductive paste.

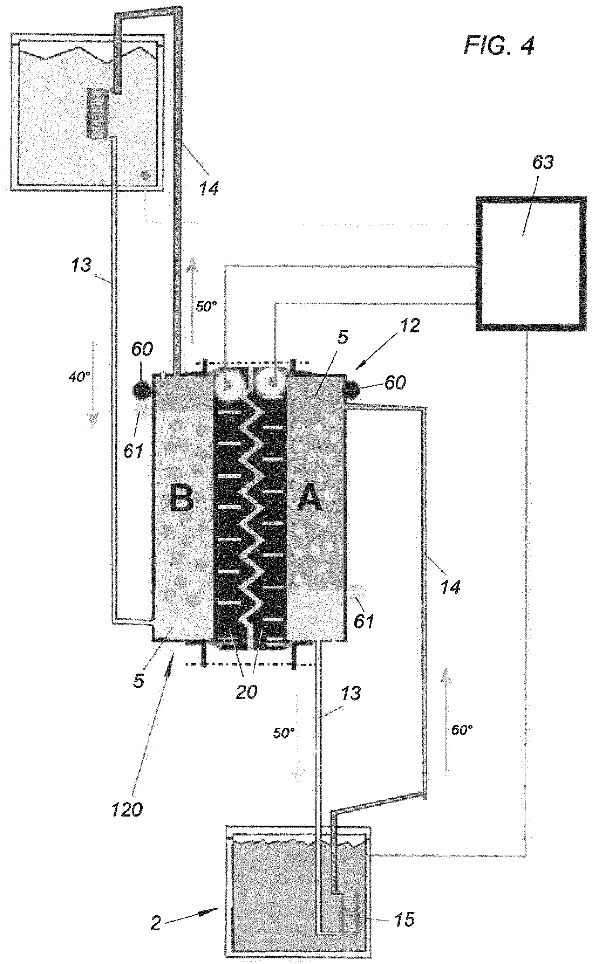

Referring to Figure 4, the functioning of the system of cooling according to the invention will now be illustrated, referring to a system containing one single primary semi-exchanger 12 associated with the secondary semi-exchanger 120 of a single rack 10.

The primary semi-exchanger 12 attached to the drawer 11 is dimensioned in such a way as to feed, via the liquid line 13, a cooling liquid having a temperature around 50°C to an electronic circuit 15, and such as to remove the quantity of heat dissipated necessary for maintaining said electronic circuit 15 at a working temperature of 60°C or lower.

The heat generated by the electronic circuit 15 makes the liquid circulating in the line 13 evaporate and the vapour generated, having a temperature of approximately 60°C, returns towards the cold area of the primary semi-exchanger 12 via the vapour piping 14, condensing in the plenum chamber 5.

In this primary semi-exchanger 12 pressure inlets 60 and/or indicators of liquid/level 61 and/or a sensor 62 of temperature of the exchange plate 20 can be provided, in order to manage in a more efficient manner the exchange temperatures of each primary semi-exchanger 12, in particular in order to transmit one or more signals to a control system 63, such as for example CPU, PLC, data logger or the like.

The heat deriving from the condensation of the vapour circulating in the vapour line 14 is transferred to the heat sink plate 20 of said primary semi-exchanger 12, which is in contact with the heat exchange plate 20 of the secondary semi-exchanger 120.

The secondary semi-exchanger 120 is designed in such a way that the heat that it receives through the heat sink plate 20 of said primary semi-exchanger 12 makes the secondary cooling liquid evaporate at a temperature of approximately 50°C. This vapour is then condensed at a temperature of approximately 40°C which is that considered in the dimensioning as maximum outside temperature of the air.

It should be noted that the increased surface temperature of the electronic components (60-70°C) makes it in fact possible to apply the functioning of heat pipes to the system of the present invention in order to dispose of directly to the exterior, and without other mediations, the heat produced by the components, excluding refrigeration machines completely.

Considering in fact a maximum temperature of the outside air of 40°C, a gradient varying from 20 to 30°C can be used, sufficient for efficiently activating a heat pipe with phase transformation.

As indicated in the accompanying drawings, the semi-exchangers 12, 120 which, joined, make up the actual exchanger of the present cooling system, can be made in the most widely differing ways in order to obtain the maximum efficiency in the transmission of heat.

In practice the present system of cooling provides for each drawer 11 of the rack 10 to have its own primary semi-exchanger 12, dimensioned on the basis of the quantity of heat to be removed (and therefore on the basis of the number of electronic elements 15) and for the secondary semi-exchanger 120 to be dimensioned in order to remove the heat transmitted by all the primary semi-exchangers 12 intended for the drawers 11 of a rack 10: thanks to the fact that one or more secondary semi-exchangers 120 of rack 10 is connected to a dry cooler 100 placed outside the room 50 (or to another type of system of dissipation of the heat of condensation of the secondary fluid of the secondary semi-exchanger 120), it is possible to subtract from the server room 50 all the heat generated by the racks 10 present in the room.

In this way, by using the present cooling system, it is possible to use conditioners of considerably smaller size with respect to what is necessary to date to keep cooled a room 50 containing the same number of racks 10.

The abovementioned dry cooler 100 can be: a) a dry cooler, static or mechanically ventilated, also with optional adiabatic pre-cooling of the air by means of finely sprayed water.

Alternatively, as already mentioned above, said secondary semi-exchanger 120 can be associated with another type of system of dissipation of the heat of condensation, different from the dry cooler 100, such as for example:
b) a condenser with direct adiabatic cooling (evaporative condenser);
c) a condenser cooled by water coming from the evaporation tower;
d) a condenser cooled directly with water, placed outside the room 50 (or also inside the room in cases c) and d)) to cool said secondary cooling fluid.

Object of the present invention is a dissipation plant comprising a cooling system as described above where each secondary semi-exchanger 120, associated with a respective rack 10, is connected to an external dry cooler 100 or to a similar machine via a series of pipings.

More particularly, the dissipation plant comprising a cooling system as described above provides for the fluid lines 13, 14 of each secondary semi-exchanger 120 to converge in respective fluid collectors 130, 140 which exit from the room 50, where said liquid collector and said vapour collector are connected to the dry cooler 100.

The cooling system of the second embodiment and third embodiment of the present invention sets out to cool the electronic elements 15 of a rack 10 without using the aforementioned intermediate exchangers between the source of heat (electronic elements 15) and external heat sink, and without any mechanical member for the heat transport, using the entire difference of temperature available between the source and external environment so as to reduce further the energy input while achieving an efficient cooling.

The cooling system of the second and third embodiments provides for the use of a single plant of heat dispersion which groups together several racks 10, without the mediation of exchangers which, by reducing the difference in temperature between the heating element (electronic element 15) and the outside, entail a smaller, albeit good, efficiency of the plant itself.

In the second and third embodiments the system is able to cool the electronic elements to a considerably lower temperature with respect to that which can be obtained with the system having the two semi-exchangers, even at the same temperature of the means disposing the heat (e.g. external air at 40°C) and at the same heat exchange surfaces.

This allows the extending of the life of the components which is notoriously inversely proportional to their working temperature.

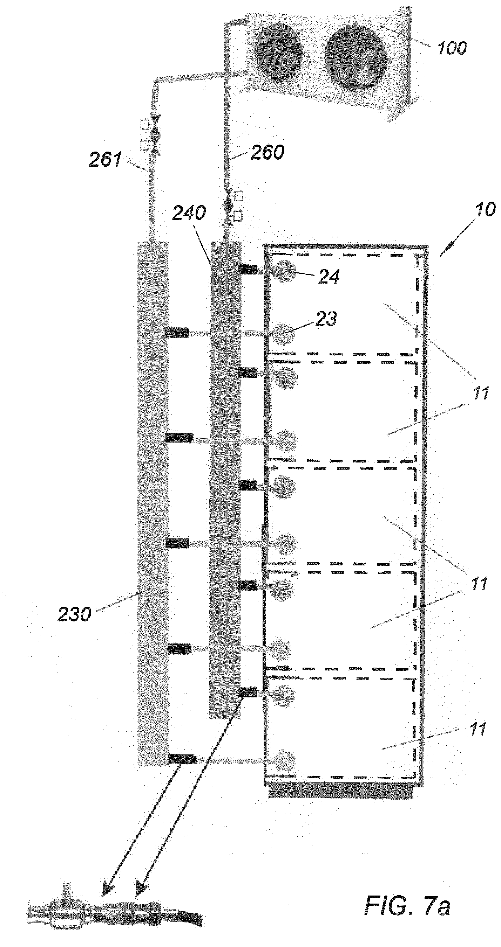

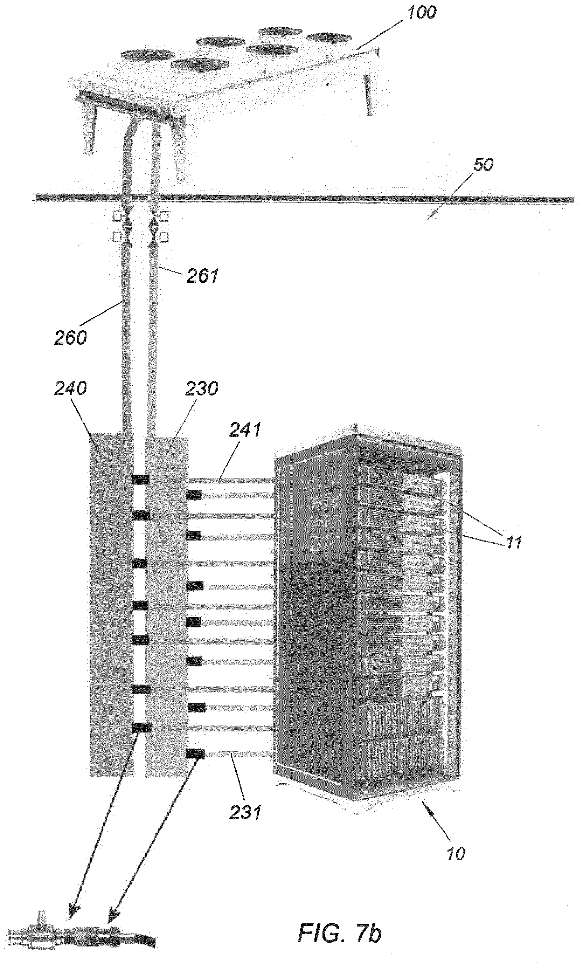

A description will now be given here below of the second embodiment of the cooling system according to the present invention, referring to Figures 7 to 11.

With respect to the first embodiment, the pipes 13 and 14 forming a heat pipe housed inside a drawer are no longer connected to a semi-exchanger with thermally conductive plate but to two small collectors 23, 24, in turn connected to larger collectors 230, 240 which serve all the drawers 11 of a rack 10 (Figs. 7a, 7b) as will be illustrated here below in greater detail.

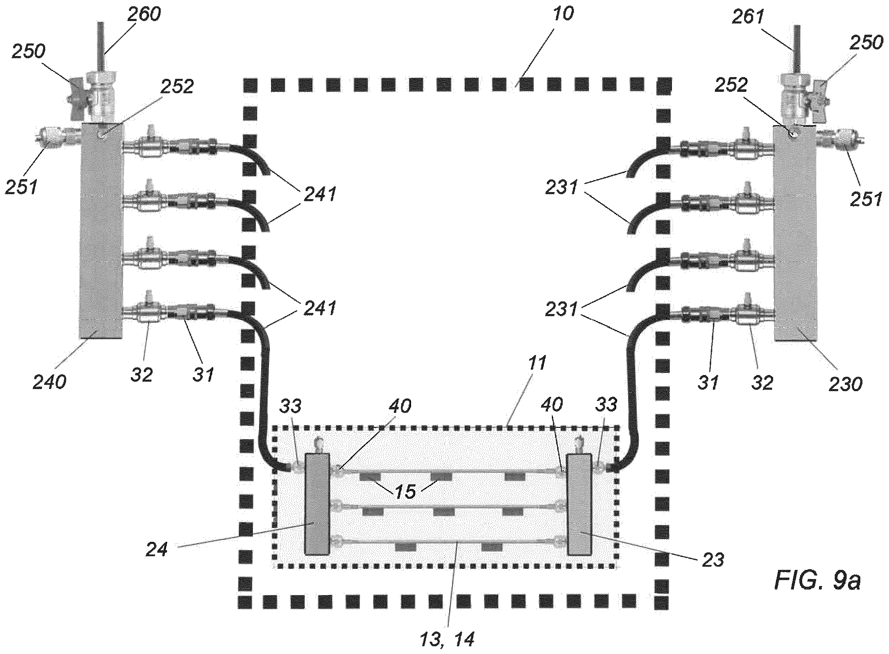

Inside each drawer 11 of each rack 10 where electronic elements 15 generating heat are present (e.g. CPU, electronic board, processor, chipset and the like), a plurality of heat pipes are placed (Fig. 9a) in contact with said electronic elements 15.

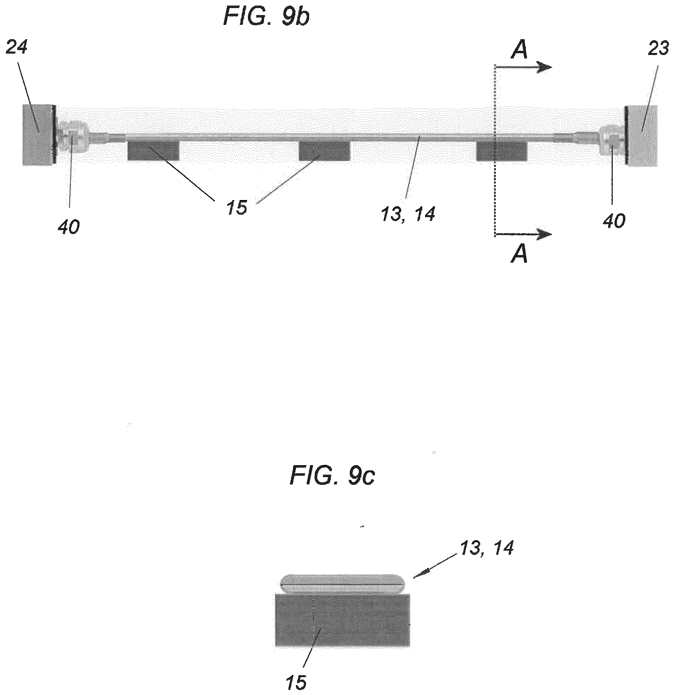

Said heat pipes are preferably in copper, with a preferably flattened profile so as to increase the surface of heat exchange with the electronic element 15 (Fig. 9c).

The slim flat heat pipes are similar to cylindrical heat pipes: they are composed of an empty receptacle, hermetically sealed, which contains a coolant fluid and of a closed capillary system of recirculation of the fluid.

Figure 9a shows a plurality of heat pipes parallel one to the other where each heat pipe is in contact with several electronic elements 15 aligned one with the other: it is in any case understood that different paths and/or arrangements of said heat pipes can be provided for without thereby departing from the scope of the present invention.

The ends of each of said heat pipes are both open in that they converge, from one side, into a small vapour collector 24, while on the other side they converge into a small liquid collector 23, both said small collectors 23, 24 being placed inside the drawer 11 of the rack 10 (Fig. 7a).

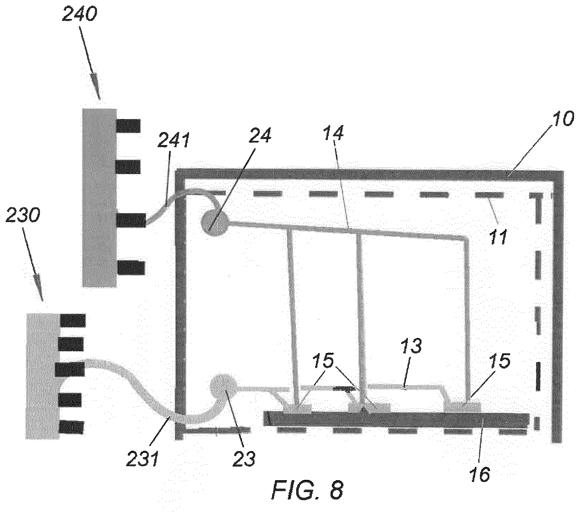

In practice, in the small vapour collector 24, the vapour lines or sections 14 of the heat pipes converge (Fig. 8), while the liquid lines or sections 13 of the heat pipes converge in the small liquid collector 23 (Fig. 8).

The connection between the ends of the liquid lines 13 and the small liquid collector 23 (hereinafter also referred to as cold collector for the sake of simplicity) takes place by means of a pipe union 40 which ensures the hermetic sealing of said lines entering the respective cold collector 23.

Also, the connection between the ends of the vapour lines 14 and the small vapour collector 24 (hereinafter also referred to as hot collector for the sake of simplicity) takes place by means of a pipe union 40 which ensures the hermetic sealing of said lines entering the respective hot collector 24.

Said pipe union 40 is blocked on the nipples welded to the collectors so as to make each of said heat pipes closed hermetically at both ends.

It is to be noted that in the case of flattened heat pipes a particular union connector is to be provided from the flat pipe to the cylindrical pipe union 40, as illustrated in Fig. 9b.

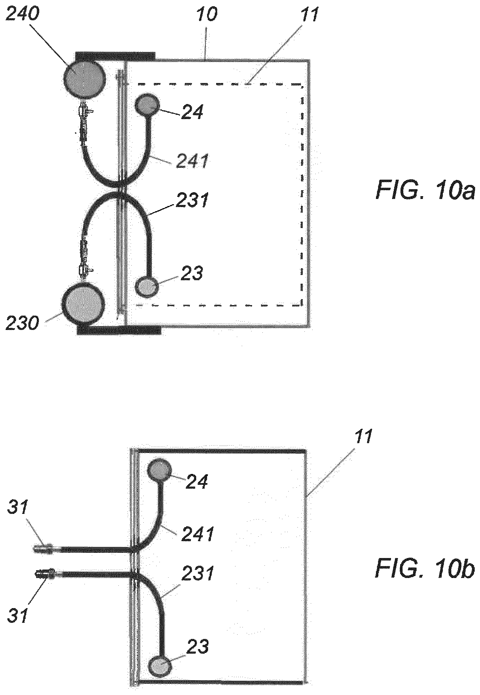

As illustrated in Figs. 10a and 7a-7b, each small liquid collector 23 placed inside each drawer 11 is then in turn connected to a larger liquid collector 230 (Fig. 9a) placed on the outer wall of the back of the rack 10, by means of a respective flexible small tube 231 which places in fluid (liquid) communication each small liquid collector 23 inside the drawer 11 with the larger external liquid collector 230 (hereinafter also referred to as larger cold collector for the sake of simplicity) associated with the rack 10.

Also, each small vapour collector 24 inside each drawer 11 is in turn connected to a larger vapour collector 240 placed externally on the back of the rack 10, using a respective flexible tube 241 which places in fluid (vapour) communication each small vapour collector 24 of the drawer 11 with the larger vapour collector 240 (hereinafter also referred to as larger hot collector for the sake of simplicity) of the rack 10.

More particularly, the two larger vapour 240 and liquid 230 collectors of the rack 10 are positioned vertically on the rear wall of the rack 10 and are mechanically integral with the metal structure of the same drawer 11 (Fig. 10a).

The flexible pipes 231, 241 to be used in the present system can be for example the known flexible tubes used in the refrigeration systems.

Each flexible tube 231, 241 of a drawer 11 is connected, at one of its ends, to the respective small liquid or vapour collector 23, 24 via a pipe union joint 33 (Fig. 9a).

Said pipe union joint 33 is then locked on a nipple welded to the small collectors 24, 23 so as to make the circuit closed hermetically.

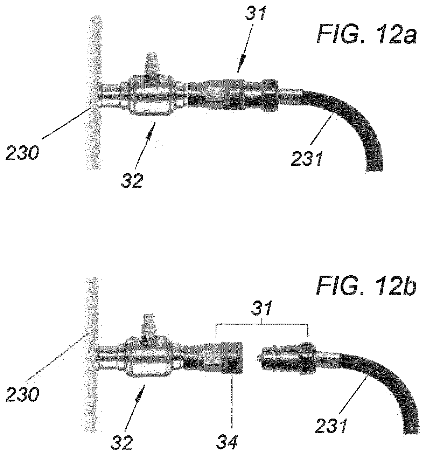

At the other end of each flexible tube 231, 241 a respective quick coupling joint 31 is provided (Fig. 12a, 12b) which engages in the respective manual tap 32 (Fig. 9a) which is mounted on the vapour 240 and liquid 230 collectors of the rack 10, so as to tightly connect the respective larger vapour 240 and liquid 230 collector of the rack 10 to the smaller vapour 24 and liquid 23 collectors of each drawer 11.

More particularly the quick coupling hydraulic joint 31, for example of the AEROQUIP type, is made up of two half-joints (Figs. 12a, 12b): a male half-joint, provided with a ring nut, which is integral with the respective flexible tube 231, 241 exiting from the drawer 11, and a female half-joint which is integral with the respective manual tap 32 placed on the vapour 240 and liquid 230 collectors of the rack 10.

Therefore, the manual tap 32 can be considered as a cut-off element having a female side suitable for the male half-joints of the sealed quick connectors 31.

The quick connectors 31 allow the disconnection or detachment of the drawer 11 without loss of fluid while the flexible tubes 231, 241 facilitate the manoeuvres of detachment/attachment without the need for precision positioning between the parts to be connected, so as to be able to extract easily from the rack the boards 15, involved in replacements or repairs, without having to put the general plant out of service.

Therefore, each drawer 11 of the rack 10 will be fitted with male half-joints of the same type, apt to engage in the female half-joints provided on the collectors 230, 240 of the rack 10 so as to form quick couplings 31.

These quick connection means ensure therefore both the sealing of said flexible tubes 231, 241 to the respective hot 240 or cold 230 collector and the rapid and tight detachment of said flexible tubes 231, 241 to allow the detachment of the drawer 11 from its rack 10.

In practice, when the drawers 11 are pushed inside their housing in the rack 10, the half-joints of the quick coupling 31 placed on the flexible tubes 231, 241 which exit from the back of each drawer 11 (Fig. 7b) engage in the corresponding half-joints placed on the collectors 230, 240 attached on the back of the rack 10, as illustrated in Figs. 10a, 10b.

After this operation of coupling of the half-joints of the quick coupling 31, the ring nut of the joint 31 will be locked for greater security of mechanical sealing so as to ensure that all the small collectors 24, 23 of the drawers 11 remain integral with the two larger hot 240 and cold 240 collectors of the rack 10, thus realising a continuous circuit between the collectors 230, 240 and the heat pipes which cool the electronic components 15.

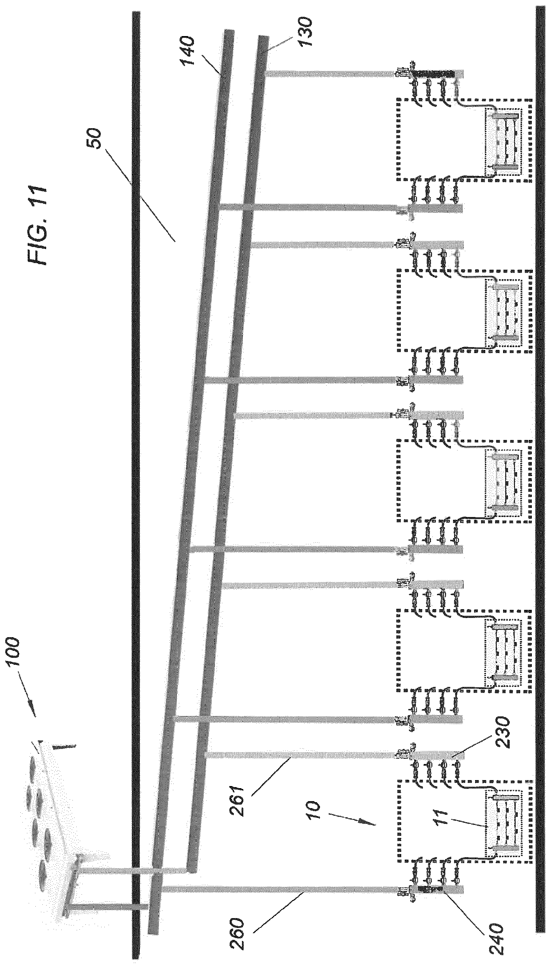

From each vapour collector 240 of each rack 10 a respective vapour delivery line (or hot gas) 260 departs which
- in the case wherein there are a plurality of racks 10 to be cooled, it converges into a general vapour collector 140 of the room 50 (Fig. 11) which in turn converges into a dry cooler 100, or another type of system of dissipation of the heat of condensation different from the dry cooler 100; or
- in the case wherein there is one single rack 10 to be cooled, it converges into a dry cooler 100, or another type of system of dissipation of the condensation heat different from the dry cooler 100 (Fig. 7a, 7b).

Moreover, from each liquid collector 230 of each rack 10 a respective condensed fluid return line (liquid) 261 departs which
- in the case wherein there are a plurality of racks 10 to be cooled (Fig. 11), converges into a general liquid collector 130 in the room 50 which in turn converges into a dry cooler 100, or another type of system of dissipation of the condensation heat different from the dry cooler 100; or
- converges into a dry cooler 100, or another type of system of dissipation of the heat, in the case wherein there is only one rack 10 to be cooled (Fig. 7a, 7b).

On each of the vapour 240 and liquid 230 collectors placed on the back of the 10 there are also provided (Fig. 9a)
- a manual tap 250, at the fluid lines 260 and 261, on the side of connection to the general plant, to hydraulically exclude a certain rack 10 from the rest of the plant during maintenance on said rack 10;
- a needle valve 251 for vacuum and for loading the cooling fluid when necessary;
- a level indicator 252 of the charge of cooling fluid.

Therefore, as illustrated in Fig. 11, the collectors 230, 240 of the various racks 10 contained in the server room 50, divided by function (vapour transport or condensed liquid transport) are connected, via appropriate pipings 260, 261, to two separate general pipings 130, 140 of greater size, to be proportioned on the basis of the thermal power to be dissipated.

In practice, said collectors 230, 240 of the racks 10 are all parallel one to the other.

Said pipings of greater size 130, 140, placed slanted as per Fig. 11 in order to facilitate the flow of the coolant and increase the efficiency of the system, will be taken outside the building of the server room 50, for example on the roof.

Moreover, said general central pipings 130, 140 will be connected one to the other and to the dry cooler ventilated (or to an adiabatic cooling tower) by means of normal joints or simply with welds. These are pipings in iron or copper, of minimal thickness, which during use will withstand a reduced pressure - that of the saturated vapour of the coolant, at the temperature of 50-60°C - which for the coolant preferred here, i.e. R134a, is approximately 14 bar.

The coolant R134a was developed to replace the R12 in automotive air conditioning systems. It is available pure or as mixture. Moreover, R134a replaces R12 and R500 in refrigerators, both in average residential and commercial applications of refrigeration. R134a was assessed as A1 by the American company ASHRAE in the safety of heating, refrigeration and air conditioning plants.

R134a also has a depletion potential equal to zero as regards the hole in the ozone layer, a global warming potential of 1430 and specific heat of 1.42 (kj)/(kg ^{∗}k).

In practice the cooling system illustrated in Fig. 11 is a loop system inside the drawers 11 and loop for the general plant.

Therefore, in this second embodiment of the cooling system according to the invention, the constructor of the electronic boards 15 and the assembler of the rack 10, must perform the circuiting of the internal cooling system according to the loop heat pipe system, distinguishing between pipes of the evaporated fluid and those of the condensed liquid.

After having performed the connections of the pipes described above and a normal tightness test similarly as in the refrigeration plants, a vacuum is created inside the entire circuit and then the loading of a calculated quantity of the cooling fluid to be used is performed, choosing it from among the ecological ones and which has acceptable pressure values at the working temperatures foreseen.

Having loaded the coolant of the plant and operated the racks 10, the entire plant made in this way behaves like a single loop heat pipe, without any interruption from the thermal viewpoint, using directly the entire difference of temperature between the external air and the electronic elements to be cooled, with the maximum yield possible.

It is to be noted that in this second embodiment by connecting the internal circuit of the drawers 11 to the outer general circuit by means of quick couplings 31 as described above, in place of the intermediate exchanger, it will be obtained that the difference in temperature which controls heat exchange is equal to 20°C (60°-40°), considering the outer air at 40°C and the temperature of the heat source at 60°C.

Given that the heat exchange depends directly on the formula W = K S Δt, where:
- W is the quantity of heat exchanged;
- K is the global transmission coefficient;
- S is the surface of contact between the heat transferring means and the cooling one;
- Δt is the difference in temperature between the two means;
it is easily noted that on a par with K and S, the heat exchanged W is greater with respect to the system with the intermediate exchanger of the first embodiment described above.

As mentioned above, the system of the present second embodiment also works without the aid of circulation pumps and the only energy required is optionally that of the fans of the dry cooler 100 (or of another type of external heat sink as mentioned above), when and if required by the variations in external temperature.

In addition to the energy saving the system of the second embodiment of the present invention allows virtually annulment of maintenance which is reduced to the sole periodical check of the dry cooler 100 or of the adiabatic tower, elements which notoriously need for no frequent maintenance operations.

The dry cooler 100, or the adiabatic tower, can be equipped with inverter control systems which will allow a reduction to the minimum of the energy used, maintaining the temperature of the coolant fluid constant.

In relation to the operations of detachment of one or more drawers 11 from the rack 10 for repairs or replacements, and of their re-insertion, it is preferable to operate as follows:
- the two manual taps 32 placed on the cold 230 and hot 240 collectors of the reference rack 10 are closed so as to close the flow of fluid in the flexible connection tubes 231, 241,
- the ring nuts of the quick connectors 31 placed on the flexible tubes 241, 231 are unscrewed and the two half-joints of the relative quick connector 31 are separated, acting with a certain force so as to separate hydraulically the involved drawer 11 from the rest of the plant which instead continues to function without interruption: no loss of coolant will take place as the joints 31 are made for the purpose,
- it is now possible to extract the involved drawer 11 to which the two flexible tubes 231, 241, which are linked to the small collectors 24, 23, remain connected (Fig. 10b),
- using simple equipment, the coolant remaining in the small collectors 23, 24 and in the flexible tubes 231, 241 is recovered so as to avoid any dispersion in the environment;
- the flexible tubes 231, 241 can also be removed, detaching them from the small collectors 23, 24 if this facilitates the work to be performed to carry out the necessary intervention: the optional detachment of the circuit boards 15 from the small collectors 23, 24 is totally simple, as well as the subsequent connection, via the pipe union fittings 40, 33 provided for the purpose.

In relation to the operations of attachment of one or more drawers 11 to the rack 10 after the abovementioned operations of repair or replacement, it is preferable to operate as follows:
- before re-inserting the extracted drawer 11, a sealing test has to be performed again on the extracted drawer 11 and subsequent vacuum to be created when the flexible tubes are connected
- the charge of refrigerant is fed via the needle fittings 250,
- having re-inserted the drawer 11, the flexible tubes 231, 241 are connected by connecting the half-joints of the quick couplings 31 one to the other and locking them with the relative ring nut,
- the two taps 250 on the collectors 240, 230 of the rack 10 are opened and everything is then ready to work.

It should be noted that before proceeding with the loading of the coolant in the whole plant it is appropriate to perform a first tightness test of the plant by means of marker gas pressurised with nitrogen. Having finished the tightness test the vacuum is created inside the plant and subsequently the coolant is loaded.

The plant formed in this way does not require any consumption of energy for the transport of the cooling fluid which takes place simply through temperature difference as in a heat pipe. It can be said that the only guiding force of the system is the actual heat to be dissipated.

The only electrical devices in motion are represented by the fans of the dry cooler 100 or of the evaporation towers, placed outside the room or area 50.

This cooling system of the second embodiment shows a hydraulic continuity between the heat pipes inside the racks and the general dissipation system, without thermal interruptions, creating a single "heat pipe", given that the first fluid and the second fluid are the same in this second embodiment.

The unquestionable advantages of the system have already been extensively described and can be summed up as:
- elimination of any mechanical member for the circulation of the fluid and therefore no consumption of energy and even less so a need for maintenance;
- possibility of transport of large quantities of heat thanks to the change of state of the fluid used (latent heat of evaporation and of condensation).

In the third embodiment the cooling system is substantially similar to that of the second embodiment with the exception of the fact that the heat pipes associated with the electronic elements 15 are pipes having only one of the two ends open - the end which disperses heat - while the other end is closed (the so-called simple or monopipe heat pipes).

The open end of the heat pipe feeds into a single small collector 61 inside the drawer 11. In this collector 61 there is the co-existence of vapour and liquid in that through the effect of the heat produced by the CPUs 15 the cooling liquid evaporates, accumulating in the upper part of the collector 61, drawing inside the tubes other liquid fluid which evaporates. The cycle continues, fed by the heat generated by the CPUs 15.

In this case too each monopipe heat pipe is connected to the small vapour/liquid collector 61 by means of a pipe union 40 to be locked on a nipple welded to the collector 61.

In this third embodiment too, the heat pipes are preferably flat.

Moreover, also in this third embodiment, intermediate exchangers are excluded, and the drawers can be extracted without loss of coolant, acting on the already provided tight quick connectors 31 and for the operations to be performed on the boards 15 of the drawer 11 the previous procedural indications apply.

## Claims

1. Cooling system of heat-producing elements, more particularly semiconductors (15) of electronic components (16) contained in drawers (11) of metal cabinets or racks (10) placed in a room (50), comprising
a first phase transition fluid, intended to cool said heat-producing elements (16) housed in at least one of said drawers (11) in order to remove the heat generated by said drawer (11) so as to maintain it at a preset temperature, said first fluid circulating in a first fluid circuit
a secondary cooling fluid, identical to said first fluid, intended to transfer directly to the outside the heat transmitted by said first fluid, said secondary cooling fluid circulating in a second fluid circuit which includes a heat sink (100) placed outside of the room (50)
said first and second fluid circuits being in fluid communication one with the other so as to form a heat pipe connected to said heat sink (100) placed outdoors,
said system being **characterised in that** in each drawer (11) of each rack (10) a plurality of heat pipes being placed in contact with said electronic elements (15),
the ends of each of said heat pipes being tightly connected, respectively, to a small hot collector (24) in which vapour lines (14) of said heat pipes converge, and to a small cold collector (23) wherein liquid lines (13) of said heat pipes converge,
each small cold collector (23) and each small hot collector (24) of each drawer (11) being inside said drawer (11) and connected with removable connection means to, respectively, a larger cold collector (230) and a larger hot collector (240), said larger collectors (230, 240) being placed outside on the back of the rack (10) and connected hydraulically to said sink (100),
said larger collectors (230, 240) and heat pipes of said electronic elements (15) forming a continuous circuit of the loop "heat pipe" type.

2. Cooling system according to claim 1, wherein the removable connection means for connection of each small cold (23) or hot collector (24) of a drawer (11) to the respective larger hot (240) or cold collector (230) comprise flexible tubes (241, 231) which hold quick connectors (31).

3. Cooling system according to claim 1 or 2, wherein each larger hot collector (240) and each larger cold collector (230) of each rack (10) converge, respectively, in a general vapour collector (140) and in a general liquid collector (130), said general collectors (130, 140) being associated with said dry cooler (100) or another heat dissipation system as defined in claim 3, said general collectors of vapour (140) and of liquid (130) being preferably placed slanted.

4. Cooling system according to claims 1-3, wherein on each of the larger hot (240) and cold (230) collectors of each rack (10) there is further provided
- a manual tap (250), at fluid lines (260, 261), to hydraulically exclude a certain rack (10) from the rest of the system;
- a needle valve (251) for vacuum and for charging the cooling fluid when necessary;
- a level indicator (252) of the charge of cooling fluid.

5. Cooling system according to clam 1, wherein the heat pipes associated with the electronic elements are pipes having one end closed while the other dispersing heat is open and converging in a single small collector (61) inside the respective drawer (11), each small connector (61) being connected, by means of removable connection means, to a respective larger hot collector (240) and cold collector (230) placed outside on the back of the rack (10) and connected hydraulically to said heat sink (100), so as to form a continuous circuit of the loop "heat pipe" type.

6. Heat dissipation system of a server room (50) comprising a cooling system as defined in any one of the preceding claims 1-5, wherein the larger cold and the larger hot collectors (230, 240) converge respectively in a general liquid collector (130) and in a general vapour collector (140) placed in said room (50), said general liquid and vapour collectors (130, 140) being associated with said dry cooler (100) or another heat dissipation system selected from:
a) a dry cooler (100), static or mechanically ventilated, also with optional adiabatic pre-cooling of the air by means of finely sprayed water;
b) a condenser with direct adiabatic cooling (evaporative condenser);
c) a condenser cooled by water coming from the evaporation tower;
d) a condenser cooled directly with water, placed outside the room (50).

## Patentansprüche

1. Kühlsystem von Wärme erzeugenden Elementen, insbesondere Halbleitern (15) von elektronischen Komponenten (16), die in Schubkästen (11) von Metallschränken oder Gestellen (10) enthalten sind, welche in einem Raum (50) aufgestellt sind, umfassend
ein Fluid des ersten Phasenübergangs, das dazu bestimmt ist, die Wärme erzeugenden Elemente (16) zu kühlen, die in mindestens einem der genannten Schubkästen (11) untergebracht sind, um die Wärme abzuführen, die von dem Schubkasten (11) erzeugt wird, um ihn so auf einer vorgegebenen Temperatur zu halten, wobei das erste Fluid in einem ersten Fluidkreislauf zirkuliert,
ein sekundäres Kühlfluid, das identisch mit dem ersten Fluid ist und dafür vorgesehen ist, die Wärme, die vom ersten Fluid übertragen wird, direkt nach außen zu leiten, wobei das sekundäre Kühlfluid in einem zweiten Fluidkreislauf zirkuliert, der eine Wärmesenke (100) enthält, die außerhalb des Raums (50) aufgestellt ist,
wobei der erste und zweite Fluidkreislauf in Fluidkommunikation miteinander stehen, um so ein Wärmerohr zu bilden, das mit der Wärmesenke (100) verbunden ist, die im Freien aufgestellt ist,
wobei das System **dadurch gekennzeichnet ist, dass** in jedem Schubkasten (11) jedes Gestells (10) eine Vielzahl von Wärmerohren in Kontakt mit den elektronischen Elementen (15) untergebracht ist,
wobei die Enden jedes der Wärmerohre jeweils mit einem kleinen Wärmekollektor (24) eng verbunden sind, in dem Dampfleitungen (14) von Wärmerohren zusammenlaufen , und mit einem kleinen Kältekollektor (23) verbunden sind, in dem Flüssigkeitsleitungen (13) der Wärmerohre zusammenlaufen,
wobei jeder kleine Kältekollektor (23) und jeder kleine Wärmekollektor (24) jedes Schubkastens (11) sich innerhalb des Schubkastens (11) befindet und mit lösbaren Verbindungsmitteln jeweils mit einem größeren Kältekollektor (230) und einem größeren Wärmekollektor (240) verbunden ist, wobei die größeren Kollektoren (230, 240) außerhalb an der Rückseite des Gestells (10) platziert und hydraulisch mit der Wärmesenke (100) verbunden sind,
wobei die größeren Kollektoren (230, 240) und die Wärmerohre der elektronischen Elemente (15) einen kontinuierlichen Kreislauf vom Schleifentyp "Wärmerohr" bilden.

2. Kühlsystem nach Anspruch 1, wobei die lösbaren Verbindungsmittel für die Verbindung von jedem kleinen Kälte- (23) oder Wärmekollektor (24) eines Schubkastens (11) mit dem jeweiligen größeren Wärme- (240) oder Kältekollektor (230) flexible Rohre (241, 231) umfassen, die Schnellverbinder (31) halten.

3. Kühlsystem nach Anspruch 1 oder 2, wobei jeder größere Wärmekollektor (240) und jeder größere Kältekollektor (230) jedes Gestells (10) jeweils in einem allgemeinen Dampfkollektor (140) und in einem allgemeinen Flüssigkeitskollektor (130) zusammenlaufen, wobei die allgemeinen Kollektoren (130, 140) mit dem Trockenkühler (100) oder einem anderen Wärmeableitungssystem verbunden sind, wie in Anspruch 3 definiert, wobei die allgemeinen Kollektoren von Dampf (140) und von Flüssigkeit (130) vorzugsweise geneigt aufgestellt werden.

4. Kühlsystem nach den Ansprüchen 1-3, wobei auf jedem von dem größeren Wärme- (240) und Kälte-(230)-Kollektor jedes Gestells (10) des Weiteren vorgesehen ist:
- ein handbetätigter Hahn (250) an Flüssigkeitsleitungen (260, 261), um ein bestimmtes Gestell (10) vom Rest des Systems auszuschließen;
- ein Nadelventil (251) für Vakuum und zum Laden des Kühlfluids, falls notwendig;
- eine Pegelanzeige (252) der Ladung von Kühlfluid.

5. Kühlsystem nach Anspruch 1, wobei die Wärmerohre, die zu den elektronischen Elementen gehören, Rohre sind, bei denen ein Ende geschlossen ist, während das andere, das Wärme verteilt, offen ist und in einen einzelnen kleinen Kollektor (61) im Innern des jeweiligen Schubkastens (11) einmündet, wobei jeder kleine Kollektor (61) mittels lösbarer Verbindungsmittel an einen jeweiligen größeren Wärmekollektor (240) und Kältekollektor (230) angeschlossen ist, die außen auf der Rückseite des Gestells (10) platziert sind und die hydraulisch mit der Wärmesenke (100) verbunden sind, um so einen kontinuierlichen Kreislauf vom Schleifentyp "Wärmerohr" zu bilden.

6. Wärmeableitungssystem eines Serverraums (50), das ein Kühlsystem umfasst, wie in einem der vorhergehenden Ansprüche 1-5 definiert, wobei der größere Kältekollektor und der größere Wärmekollektor (230, 240) jeweils in einen allgemeinen Flüssigkeitskollektor (130) und in einen allgemeinen Dampfkollektor (140) einmünden, die in dem Raum (50) aufgestellt sind, wobei die allgemeinen Flüssigkeits- und Dampfkollektoren (130, 140) in Verbindung mit dem Trockenkühler (100) oder einem anderen Wärmeableitungssystem stehen, das ausgewählt wird aus:
a) einem Trockenkühler (100), statisch oder mechanisch belüftet, auch mit optionaler adiabatischer Vorkühlung der Luft mittels fein versprühtem Wasser;
b) einem Kondensator mit direkter adiabatischer Kühlung (Verdunstungskondensator);
c) einem Kondensator, der durch Wasser gekühlt wird, das vom Verdunstungsturm kommt;
d) einem Kondensator, der direkt mit Wasser gekühlt wird und der außerhalb des Raums (50) aufgestellt ist.

## Revendications

1. Système de refroidissement d'éléments de production de chaleur, plus particulièrement des semi-conducteurs (15) de composants électroniques (16) contenus dans des tiroirs (11) d'armoires métalliques ou baies (10) placées dans une salle (50), comprenant :
un premier fluide de transition de phase prévu pour refroidir lesdits éléments de production de chaleur (16) logés dans au moins l'un desdits tiroirs (11) afin d'enlever la chaleur générée par ledit tiroir (11) de manière à le maintenir à une température prédéfinie, ledit premier fluide circulant dans un circuit de premier fluide,
un deuxième fluide de refroidissement, identique audit premier fluide, prévu pour directement transférer vers l'extérieur la chaleur transmise par ledit premier fluide, ledit deuxième fluide de refroidissement circulant dans un circuit de deuxième fluide qui comprend un dissipateur de chaleur (100) placé à l'extérieur de la salle (50),
lesdits circuits des premier et deuxième fluides étant en communication fluidique l'un avec l'autre de manière à former un caloduc connecté audit dissipateur thermique (100) placé à l'extérieur,
ledit système **se caractérisant en ce que**, dans chaque tiroir (11) de chaque baie (10), une pluralité de caloducs sont placés en contact avec lesdits éléments électroniques (15),
les extrémités de chacun desdits caloducs étant respectivement connectées de manière étanche à un petit collecteur chaud (24) dans lequel des conduites de vapeur (14) desdits caloducs convergent et à un petit collecteur froid (23) où des conduites de liquide (13) desdits caloducs convergent,
chaque petit collecteur froid (23) et chaque petit collecteur chaud (24) de chaque tiroir (11) étant à l'intérieur dudit tiroir (11) et connecté, avec des moyens de connexion amovibles, respectivement à un plus grand collecteur froid (230) et un plus grand collecteur chaud (240), lesdits plus grands collecteurs (230, 240) étant placés à l'extérieur sur l'arrière de la baie (10) et connectés hydrauliquement audit dissipateur thermique (100),
lesdits plus grands collecteurs (230, 240) et caloducs desdits éléments électroniques (15) formant un circuit continu de type « caloduc » en boucle.

2. Système de refroidissement selon la revendication 1, dans lequel les moyens de connexion amovibles pour la connexion de chaque petit collecteur froid (23) ou chaud (24) d'un tiroir (11) au plus grand collecteur chaud (240) ou froid (230) respectif comprennent des tubes flexibles (241, 231) qui détiennent des raccords rapides (31).

3. Système de refroidissement selon la revendication 1 ou 2, dans lequel chaque plus grand collecteur chaud (240) et chaque plus grand collecteur froid (230) de chaque baie (10) converge respectivement dans un collecteur général de vapeur (140) et un collecteur général de liquide (130), lesdits collecteurs généraux (130, 140) étant associés audit aéroréfrigérant (100) ou autre système de dissipation de chaleur tel que défini dans la revendication 3, lesdits collecteurs généraux de vapeur (140) et de liquide (130) étant de préférence placés de manière inclinée.

4. Système de refroidissement selon les revendications 1-3, dans lequel, sur chacun des plus grands collecteur chaud (240) et collecteur froid (230) de chaque baie (10), on fournit également
- un robinet manuel (250), au niveau de conduites de fluide (260, 261), pour exclure hydrauliquement une certaine baie (10) du reste du système ;
- une soupape à pointeau (251) pour le vide et pour charger le fluide de refroidissement si nécessaire ;
- un indicateur de niveau (252) de la charge du fluide de refroidissement.

5. Système de refroidissement selon la revendication 1, dans lequel les caloducs associés aux éléments électroniques sont des tuyaux, ayant une extrémité fermée alors que l'autre dispersant la chaleur est ouverte, et convergent dans un unique petit collecteur (61) à l'intérieur du tiroir (11) respectif, chaque petit collecteur (61) étant connecté, au moyen d'un moyen de connexion amovible, à un plus grand collecteur chaud (240) et collecteur froid (230) respectifs placés à l'extérieur sur l'arrière de la baie (10) et connectés hydrauliquement audit dissipateur thermique (100) de manière à former un circuit continu de type « caloduc » en boucle.

6. Système de dissipation de chaleur d'une salle de serveur (50) comprenant un système de refroidissement tel que défini par l'une quelconque des revendications 1-5 précédentes, dans lequel les plus grands collecteurs froid et chaud (230, 240) convergent respectivement dans un collecteur général de liquide (130) et dans un collecteur général de vapeur (140) placés dans ladite salle (50), lesdits collecteurs généraux de liquide et de vapeur (130, 140) étant associés audit aéroréfrigérant (100) ou autre système de dissipation de chaleur sélectionné parmi :
a) un aéroréfrigérant (100) statique ou ventilé mécaniquement, également avec refroidissement préliminaire adiabatique de l'air au moyen d'eau finement pulvérisée ;
b) un condenseur avec refroidissement adiabatique direct (condenseur d'évaporation) ;
c) un condenseur refroidi par de l'eau venant de la tour d'évaporation ;
d) un condenseur refroidi directement avec de l'eau, placé à l'extérieur de la salle (50).
